Europäisches Patentamt

European Patent Office

Office européen des brevets

(11) Veröffentlichungsnummer: **0 096 369**
**B1**

(12) **EUROPÄISCHE PATENTSCHRIFT**

(45) Veröffentlichungstag der Patentschrift: **17.05.89**

(21) Anmeldenummer: **83105462.2**

(22) Anmeldetag: **01.06.83**

(51) Int. Cl.⁴: **G 06 F 11/20**

(54) **Speicherbaustein.**

(30) Priorität: **04.06.82 DE 3221268**

(43) Veröffentlichungstag der Anmeldung:
**21.12.83 Patentblatt 83/51**

(45) Bekanntmachung des Hinweises auf die
Patenterteilung:
**17.05.89 Patentblatt 89/20**

(84) Benannte Vertragsstaaten:
**AT DE FR GB IT**

(56) Entgegenhaltungen:
**US-A-3 654 610**
**US-A-4 228 528**

(73) Patentinhaber: **Siemens Aktiengesellschaft**
**Berlin und München**
**Wittelsbacherplatz 2**
**D-8000 München 2 (DE)**

(72) Erfinder: **Häusele, Hans, Dipl.-Ing.**
**Wetzelstrasse 4**
**D-8000 München 71 (DE)**

Courier Press, Leamington Spa, England.

## Beschreibung

Die Erfindung bezieht sich auf einen integrierten Speicherbaustein mit redundanten Speicherzellen und/oder -Spalten nach dem Oberbegriff des Patentanspruches 1.

Bei der Prüfung eines aus einer Vielzahl von integrierten Speicherbausteinen bestehenden Speichers ist es sehr schwierig und nur mit einem hohen Arbeits- und Zeitaufwand möglich, einen fehlerhaften Speicherbaustein zu identifizieren, so daß es ratsam ist, nur vorgeprüfte Speicherbausteine zu verwenden. Aber auch die Prüfung von hochintegrierten Speicherbausteinen mit speziellen Prüfprogrammen, insbesondere die Untersuchung der Störbeeinflussung benachbarter Speicherzellen, ist sehr zeitaufwendig. Die Prüfung eines Bausteins mit n Speicherzellen erfordert $2\,n^2$ Prüfschritte, wenn die Topographische Anordnung der Speicherzellen nicht bekannt ist (Microelectronics Journal Vol. 10, No. 1, 1979, Seiten 27 bis 34). Das führt bei hochintegrierten Speicherbausteinen zu Prüfkosten, die etwa 30% und mehr der gesamten Herstellungskosten betragen. Man ist daher dazu übergegangen, den Anwendern Angaben über die Topographie zu machen. Dabei wird angegeben, in welcher Reihenfolge externe Adressen an die Adresseingänge anzulegen sind, um alle Zeilen und Spalten im Speicherzellenfeld fortlaufend zu erfassen. Bei vollständiger Kenntnis der Topographie reduziert sich die Zahl der Prüfschritte auf 2n, weil nun nicht mehr jede Speicherzelle gegen jede andere, genauer gesagt, jede Adresse gegen jede andere geprüft werden muß.

Trotz beachtlicher Fortschritte in der Fertigungstechnik nimmt der Anteil von fehlerhaften Speicherbausteinen am Gesamtausstoß infolge der ständig erhöhten Integrationsdichte mit der damit verbundenen Verkleinerung der linearen Abmessungen eher zu als ab. Es werden daher immer häufiger redundante Speicherzellen und/oder -Spalten vorgesehen, durch die während der Scheibenmessung mit Hilfe spezieller Umprogrammierungselemente fehlerhafte Zeilen und/oder Spalten des Speicherzellenfeldes ersetz werden. Da so aus einem an sich fehlerhaften und daher unverkäuflichen Chip ein voll funktionsfähiges entsteht, können sich erhebliche Ausbeutesteigerungen (bis zum Faktor 10) ergeben.

Es ist bekannte, redundante Zeilen bzw. Spalten blockweise an die Ränder des normalen Zellenfeldes zu verlegen (Redundancy ... Solution for the 80's, Intel Corporation, USA, 1980).

Die Ersatzschaltung hat allerdings zur Folge, daß die ursprünglich vorhandene Kenntnis der Nachbarschaftsbeziehung der Speicherzellen verloren geht, weil die Ersatzschaltung für jeden Baustein verschieden ist. Damit sind für die Prüfung solcher Bausteine wieder nichtlineare Prüfprogramme mit ihrem hohen Zeitbedarf notwendig. Als Ausweg aus dieser Schwierigkeit könnte daran gedacht werden, jedem Speicherbaustein ein Ersatzschaltungsprotokoll mitzugeben. Dies wäre jedoch aus mehreren Gründen praktisch undurchführbar.

Der Erfindung liegt die Aufgabe zugrunde, einen Speicherbaustein mit redundanten Speicherelementen so auszubilden, daß auch ohne Kenntnis der ersetzten Zeilen und/oder Spalten eine vollständige Pfüfung mit linear von der Zahl der Speicherzellen abhängigen Prüfzeiten möglich ist. Lösungen dieser Aufgabe sind den Patentansprüchen 1 und 2 zu entnehmen.

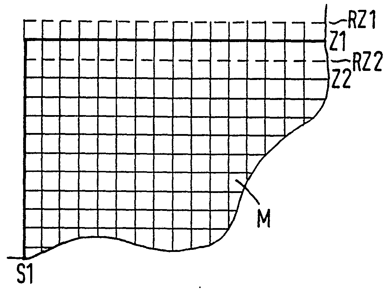

Im folgenden wird die Erfindung anhand eines in der Zeichnung schematisch dargestellten Ausführungsbeispieles näher beschrieben.

Die Figur zeigt eine Möglichkeit der Anordnung von redundanten Zeilen und Spalten relativ zum Zellenfeld M mit dem Zeil, kurze Prüfzeiten zu erhalten. Bei dieser Anordnung sind außerhalb des Zellenfeldes M an dessen Rändern jeweils nur eine Ersatzzeile bzw. Ersatzspalte, d.h. insgesamt maximal zwei Ersatzzeilen und zwei Ersatzspalten vorgesehen. Für den der Fig. zugrundegelegten Fall, daß mehr als die genannten Ersatzelemente bereitgestellt werden sollen, werden die weiteren Ersatzzeilen und/oder Ersatzspalten derart in das Innere des Zellenfeldes M verlegt, daß sich zwischen zwei redundanten Zeilen bzw. Spalten mindestens eine Zeile bzw. Spalte des Zellenfeldes M befindet.

Bei der gezeigten Anordnung, die nur einen Abschnitt eines Zellenfeldes M schematisch zeigt, sind zwei Ersatzzeilen RZ1 und RZ2 an einem Rand des Zellenfeldes M vorgesehen. Die Ersazzeile RZ1 liegt außerhalb des Zellenfeldes M, dessen äußere Zeile Z1 und Spalte S1 wieder durch dickere Striche hervorgehoben sind. Die zweite Ersatzzeile RZ2 befindet sich zwischen der äußeren Zeile Z1 des Zellenfeldes M und der nach innen folgenden Zeile Z2. Eine weitere Ersatzzeile müßte gegebenenfalls zwischen der zweiten und dritten Zeile des Zellenfeldes M untergebracht werden.

Sollen auch oder nur Ersatzspalten bereitgestellt werden, dann gilt für deren Anordnung sinngemäß dasselbe.

Die beschriebene Anordnung der Ersatzelemente (Zeilen oder Spalten) hat zur Folge, daß die Adressen der jeweiligen Nachbarelemente (Zeilen oder Spalten des Zellenfeldes M) zu den Ersatzelementen bekannt sind. Bei der Prüfung solcher Speicherbausteine kann also in folgender Weise vorgegangen werden:

Zunächst wird das gesamte Zellenfeld unter Verwendung aller Adressen auf der Grundlage der (mit Ausnahme der ersatzgeschalteten Elemente) als bekannt vorausgesetzten Topographie geprüft. Damit sind alle Nachbarschaftsbeziehungen zwischen den nichtersatzgeschalteten Elementen erfaßt.

Dann werden alle Nachbarelemente von Ersatzelementen gegen alle übrigen Adressen geprüft. Dabei werden auch Nachbarschaftsstörungen zu Ersatzelementen, deren Adressen ja nicht bekannt und in der Regel von Baustein zu Baustein verschieden sind, erkannt. Zwar erhöht sich dabei die Prüfzeit je Ersatzelement etwa um die Zeit des ersten Prüfdurchgangs, doch das Prüfprogramm bleibt linear.

Es ist noch darauf hinzuweisen, daß bei der Anordnung nach der Fig. die Abstände zwischen den Ersatzzeilen und den benachbarten Zeilen des Zellenfeldes bzw. zwischen den Ersatzspalten und den benachbarten Spalten des Zellenfeldes größer als die im Zellenfeld sonst vorgegebenen Abstände gemacht werden können. Damit ist es ohne großes Risiko möglich, die gesamte Prüfung des Bausteins auf den oben angegebenen ersten Durchgang zu beschränken.

**Patentansprüche**

1. Integrierter Speicherbaustein mit mindestens einem normal adressierbaren Zellenfeld (M) aus matrixförmig angeordneten Speicherzellen und mit zeilenweise (RZ1) und/oder spaltenweise an den Rändern des Zellenfeldes (M) angeordneten redundanten Speicherzellen, die anstelle von fehlerhaften Zeilen und/oder Spalten im Zellenfeld (M) anschließbar sind, dadurch gekennzeichnet, daß außerhalb des Zellenfeldes (M) redundante Zeilen (RZ1) bzw. Spalten höchstens einreihig angeordnet sind und daß weitere redudante Zeilen (RZ2) bzw, Spalten derart in das Innere des Zellenfeldes (M) verlegt sind, daß sich zwischen zwei redundanten Zeilen (RZ1, RZ2) bzw. Spalten mindestens eine Zeile (Z1) bzw. Spalte des Zellenfeldes (M) befindet.

2. Speicherbaustein nach Anspruch 1, dadurch gekennzeichnet, daß die Abstände zwischen redundanten Zeilen (RZ1, RZ2) und benachbarten Zeilen (Z1, Z2) des Zellenfeldes (M) bzw. zwischen redundanten Spalten und benachbarten Spalten des Zellenfeldes (M) deutlich größer als die entsprechenden sonstigen Abstände innerhalb des Zellenfeldes (M) sind.

**Revendications**

1. Module de mémoire intégré comportant au moins un réseau de cellules (M) adressable normalement et formé par des cellules de mémoire disposées sous la forme d'une matrice et des cellules de mémoire redondantes disposées suivant des lignes (RZ1) et/ou des colonnes au niveau des bords du réseau de cellules (M) et pouvant être raccordées à la place de lignes et/ou colonnes défectueuses dans le réseau de cellules (M), caractérisé par le fait que des lignes redondantes (RZ1) ou des colonnes redondantes sont disposées, au maximum suivant une rangée, à l'extérieur du réseau de cellules (M) et que d'autres lignes redondantes (RZ2) ou d'autres colonnes redondantes sont disposées à l'intérieur du réseau de cellules (M) de telle sorte qu'au moins une ligne (Z1) ou une colonne du réseau de cellules (M) est située entre deux lignes redondantes (RZ1, RZ2) ou de colonnes redondantes.

2. Module de mémoire suivant la revendication 1, caractérisé par le fait que les distances entre des lignes redondantes (RZ1, RZ2) et des lignes voisines (RZ1, RZ2) du réseau de cellules (M) ou entre des colonnes redondantes des colonnes voisines du réseau de cellules (M) sont nettement supérieures aux autres distances correspondantes à l'intérieur du réseau de cellules (M).

**Claims**

1. Integrated memory circuit having at least one normally addressable cell field (M) of memory cells arranged in matrix fashion and having redundant memory cells arranged in rows (RZ1) and/or in columns at the edges of the cell field (M), which redundant memory cells can be connected instead of faulty rows and/or columns in the cell field (M), characterized in that redundant rows (RZ1) or columns are arranged at most in a single row outside the cell field (M), and in that further redundant rows (RZ2) or columns are moved into the inside of the cell field (M) in such a manner that at least one row (Z1) or column of the cell field (M) is located between two redundant rows (RZ1, RZ2) or columns.

2. Memory circuits according to Claim 1, characterized in that the distances between the redundant rows (RZ1, RZ2) and adjacent rows (Z1, Z2) of the cell field (M), or between redundant columns and adjacent columns of the cell field (M) respectively, are clearly greater than the corresponding other distances within the cell field (M).

RZ1

Z1

RZ2

Z2

M

S1